# FASCICULE DE BREVET EUROPEEN

(11) **EP 4 567 441 B1**
(45) Date de publication et mention de la délivrance du brevet: **01.07.2026**
(21) Numéro de dépôt: 24216791.4
(22) Date de dépôt: 02.12.2024
(51) Int. Cl.: G01R 31/12, G01R 31/58

(54) **ASSEMBLAGE ET CELLULE POUR ÉTUDE DU VIEILLISSEMENT DE CÂBLE HAUTE TENSION**
ANORDNUNG UND ZELLE ZUR UNTERSUCHUNG DER ALTERUNG VON HOCHSPANNUNGSKABELN
ASSEMBLY AND CELL FOR STUDYING AGEING OF A HIGH-VOLTAGE CABLE

(30) Priorité: 04.12.2023 FR 2313513
(43) Date de publication de la demande: 11.06.2025
(73) Titulaire: Commissariat à l'Energie Atomique et aux Energies Alternatives, 75015 Paris (FR)
(72) Inventeur: TIQUET, Pascal, 38054 GRENOBLE Cedex 09 (FR); AUGER, Aurélien, 38054 GRENOBLE Cedex 09 (FR)
(74) Mandataire: Hautier IP

(56) Documents cités:
- EP-B1- 1 490 672
- EP-B1- 2 818 881
- EP-B1- 2 831 606
- LIU YONG ET AL: "Thermal Aging Evaluation of XLPE Power Cable by Using Multidimensional Characteristic Analysis of Leakage Current", POLYMERS, vol. 14, no. 15, 1 August 2022 (2022-08-01), CH, pages 3147, XP093176604, ISSN: 2073-4360, DOI: 10.3390/polym14153147
- MUGALA G ET AL: "High Frequency Characteristics of Water-Tree Degraded XLPE Insulation in Power Cables", IEEE TRANSACTIONS ON DIELECTRICS AND ELECTRICAL INSULATION, IEEE SERVICE CENTER, PISCATAWAY, NJ, US, vol. 14, no. 5, 1 October 2007 (2007-10-01), pages 1271 - 1277, XP011193482, ISSN: 1070-9878, DOI: 10.1109/TDEI.2007.4339488

## Description

### DOMAINE TECHNIQUE

La présente invention concerne le domaine de l'étude du vieillissement de câble électrique, et notamment de câble électrique haute tension. Elle trouve pour application particulièrement avantageuse la prédiction du comportement mécanique et électrique de composant de câble de haute tension, dans le but d'en améliorer la fabrication et/ou d'en prévoir la durée de vie.

### ETAT DE LA TECHNIQUE

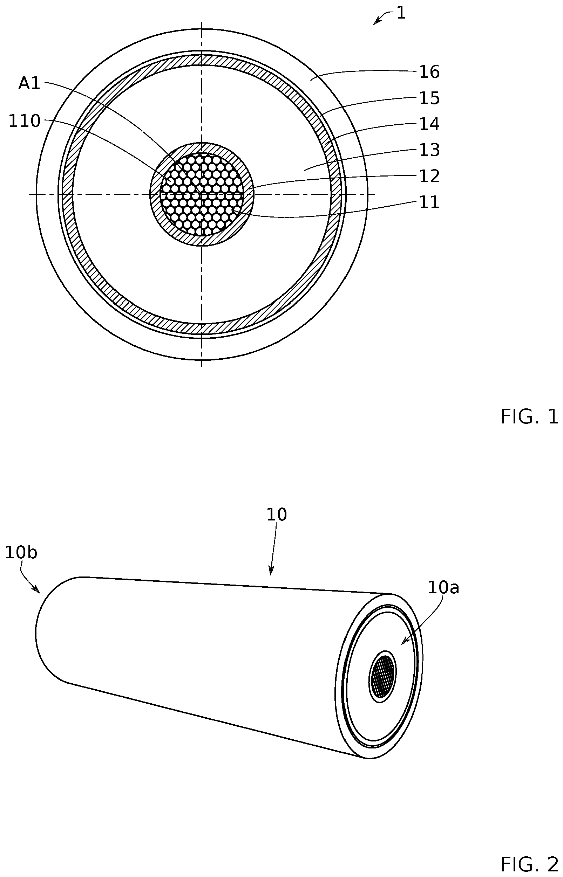

De façon générale, et par exemple illustré en figure 1, un câble haute tension comprend dans sa section transversale une âme 11 entourée d'une gaine semi-conductrice interne 12, elle-même entourée d'un matériau isolant 13 à base d'un polymère électriquement isolant. L'âme 11 comprend généralement des fils métalliques 110, par exemple tressés entre eux. Le matériau isolant 13 est typiquement entouré d'une gaine semi-conductrice externe 14, entourée d'un blindage électromagnétique 15 puis d'une gaine extérieure 16 électriquement isolante. De même, EP 2 818 881 B1 décrit un ensemble conducteur utilisé dans un réseau électrique, comportant une électrode de détection disposée radialement à l'extérieur de la couche isolante et un élément d'espacement électriquement isolant disposé radialement entre la couche isolante et l'électrode de détection.

La rupture des câbles haute tension est souvent due au matériau isolant entourant la gaine semi-conductrice interne, ou au matériau de la gaine semi-conducteur externe. Il existe donc un besoin d'étudier le vieillissement de ces matériaux d'intérêt afin de fiabiliser les câbles à haute tension et/ou pouvoir prédire leur durée de vie.

La modélisation, la prédiction et l'expertise du vieillissement des diélectriques et des semi-conducteurs composant les câbles à haute tension est typiquement faite par une approche de vieillissement accéléré sous des conditions couplées entre une exposition à un courant électrique, et des sollicitations mécanique et/ou thermique dans un environnement représentatif de l'utilisation du câble haute tension, par exemple sans oxygène avec la présence d'humidité.

Pour les câbles électriques haute tension, la démarche utilisée par les câbliers est d'élaborer des mini-câbles modèles, de section et de longueur inférieures aux câbles haute tension. Ces mini-câbles sont ensuite vieillis dans des enceintes thermo-régulée. Ces enceintes sont généralement associées à un générateur haute tension externe pour alimenter électriquement les câbles. Cette technique permet de coupler deux facteurs d'accélération : la température et le champ électrique.

Toutefois, l'approche par mini-câbles offre peu de volume de matériau pour étudier les évolutions des propriétés des matériaux. Les études matériaux demandent en effet une grande quantité d'échantillons pour établir correctement les statistiques de fragilisation mécaniques et diélectriques. En outre, la microstructure, l'histoire thermomécanique et l'état mécanique d'un mini-câble diffère de celle d'un vrai câble haute tension. Ces différences posent un problème de représentativité pour les études de vieillissement et la prédiction de durée de vie du câble.

Une autre solution utilisée consiste à mettre en forme le matériau isolant à l'état fondu pour élaborer des éprouvettes spécifiques dites de type Rogowski, sur laquelle est conduite l'étude de vieillissement. On utilise pour cela généralement des granules du même polymère que celui utilisé dans un câble haute tension, qui est mis en forme par compression pour fabriquer l'éprouvette. Dans le cas de l'élaboration des éprouvettes de Rogowski, le degré de représentativité est donc encore plus faible. La remise en forme du matériau conduit à s'écarter significativement de la réalité du matériau, et de son histoire thermo-mécanique lors de la fabrication du câble haute tension. En outre, l'élaboration de chaque éprouvette est fastidieuse, ce qui limite les statistiques d'étude de vieillissement.

Un objet de la présente invention est donc de proposer une solution améliorant l'étude du vieillissement de câbles électriques haute tension.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un premier aspect on prévoit un procédé de fabrication d'un assemblage pour étude du vieillissement d'un câble électrique, et notamment un câble haute tension, le procédé comprenant :
- une formation d'un empilement multicouche comprenant la superposition au moins partielle :
   ∘ d'une première couche dite d'électrode, à base d'un matériau électriquement conducteur,
   ∘ d'au moins une couche à base d'un polymère électriquement isolant, dite première couche de polymère isolant,
   ∘ d'une deuxième couche dite d'électrode, à base d'un matériau électriquement conducteur, de sorte que la première couche de polymère isolant est disposée entre les première et deuxième couches d'électrodes, et
   ∘ d'une couche séparatrice au moins en partie superposée avec l'ensemble formé par les première et deuxième couches d'électrodes et la première couche de polymère isolant,
- un enroulement de l'empilement multicouche au moins en partie sur lui-même autour d'une direction longitudinale pour former l'assemblage.

Le vieillissement électrique d'un câble est fonction de la force électromotrice dans le câble. Cette force dépend de la tension et de l'épaisseur de matériau traversé par le courant électrique. L'utilisation d'une couche de polymère isolant dans un empilement, cette couche étant plus particulièrement fine par rapport aux solutions existantes, permet de réduire le voltage nécessaire pour obtenir une exposition à un courant électrique plus représentative de l'usure réelle d'un câble haute tension. L'étude de vieillissement est ainsi facilitée et est en outre plus représentative du vieillissement réel.

En outre, le polymère isolant étant sous forme d'une couche intercalée entre les électrodes, l'assemblage permet de mieux exposer la couche de polymère isolant à des sollicitations électriques et thermiques par rapport aux solutions existantes. L'étude de vieillissement est ainsi fiabilisée.

Cette configuration d'empilement multicouche permet un vieillissement accéléré de cette couche tout en obtenant un volume de matériau suffisant pour effectuer l'étude du vieillissement, et notamment les analyses mécaniques et diélectriques.

En outre, le montage de l'assemblage est simplifié par rapport aux solutions existantes, ce qui facilite la réalisation de plusieurs assemblages pour améliorer les statistiques d'une étude de vieillissement.

L'étude de vieillissement est donc améliorée, notamment par rapport aux solutions existantes mettant en œuvre des mini-câbles.

Un deuxième aspect concerne un assemblage pour l'étude du vieillissement d'un câble électrique, et notamment un câble haute tension. L'assemblage comprend un empilement multicouche au moins en partie enroulé sur lui-même autour d'une direction longitudinale, l'empilement multicouche comprenant :
- une première et une deuxième couches, dites d'électrodes, à base d'un matériau électriquement conducteur,
- une première couche à base d'un polymère électriquement isolant de câble de haute tension dont le vieillissement est à étudier, dite première couche de polymère isolant, et disposée entre les première et deuxième électrodes, et
- une couche séparatrice configurée pour isoler électriquement les première et deuxième couches d'électrodes entre elles, dans l'empilement multicouche enroulé.

L'assemblage présente ainsi les effets et avantages décrits précédemment en référence au procédé de fabrication selon le premier aspect.

Un troisième aspect concerne une cellule pour l'étude du vieillissement d'un câble haute tension, comprenant :
- l'assemblage selon le deuxième aspect ou fabriqué selon le premier aspect, et
- une capsule configurée pour alimenter électriquement l'assemblage, la capsule comprenant :
   ∘ un corps, un premier bouchon et un deuxième bouchon, définissant un volume intérieur clos, la capsule étant configurée pour recevoir l'assemblage dans le volume intérieur clos,
   ∘ deux électrodes chacune configurée pour raccorder une couche d'électrode distincte de l'assemblage.

La cellule permet ainsi de réaliser l'étude de vieillissement de l'assemblage par le raccordement électrique à une source d'alimentation électrique externe.

Un quatrième aspect concerne un système comprenant plusieurs cellules selon le troisième aspect et un boitier configuré pour recevoir et alimenter électriquement les cellules.

Le système permet ainsi de paralléliser l'étude de vieillissement pour plusieurs cellules. Cela permet notamment de pouvoir obtenir des statistiques de vieillissement pour des échantillons d'un même type de câble électrique. En synergie avec des capsules étanches, cela permet d'effectuer en parallèle une étude de vieillissement pour des conditions de vieillissement différentes. Le système est donc particulièrement avantageux compte-tenu de la durée des études de vieillissement, qui peuvent par exemple durer plusieurs années.

Un cinquième aspect concerne un procédé d'étude du vieillissement d'un câble électrique, et notamment un câble haute tension, le procédé comprenant :
- une exposition d'au moins un assemblage selon le deuxième aspect ou fabriqué selon le procédé selon le premier aspect, à un courant électrique,
- au moins une mesure d'une propriété électrique, et par exemple de la résistance interne, d'au moins un assemblage de façon à obtenir une donnée représentative du vieillissement d'un câble haute tension.

L'assemblage peut être compris dans une cellule selon le troisième aspect. L'assemblage peut être compris dans une cellule selon le quatrième aspect.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants.
La figure 1 représente une vue en coupe transversale d'un câble haute tension, selon un exemple de réalisation.
La figure 2 représente une vue de côté d'une portion de câble haute tension, selon un exemple de réalisation.
La figure 3 représente une vue d'une extrémité d'une portion de câble haute tension découpée, selon un exemple de réalisation.
La figure 4 représente une vue en perspective des étapes de dressage de la portion de câble haute tension découpée, selon un exemple de réalisation.
La figure 5 représente une vue en perspective du détourage de la portion de câble haute tension, selon un exemple de réalisation.
Les figures 6A à 6C représentent respectivement des vues de côté, du dessus et d'un autre côté de l'empilement multicouche avant son enroulement, selon un exemple de réalisation.
La figure 7 représente une vue en coupe transversale de l'assemblage, selon un exemple de réalisation.
La figure 8 représente une vue en coupe transversale de la cellule comprenant l'assemblage illustré en figure 7, selon un exemple de réalisation.
La figure 9 représente une vue en coupe transversale du système, selon un exemple de réalisation.
La figure 10 représente une vue en coupe transversale du système illustré en figure 9, dans une enceinte thermorégulée, selon un exemple de réalisation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions relatives des couches et épaisseurs de couche dans l'empilement ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, le procédé comprend en outre :
- une fourniture d'une portion de câble haute tension comprenant une âme s'étendant selon une direction d'extension principale du câble et entourée autour de ladite direction par un matériau à base du polymère électriquement isolant,
- une formation d'un film à base du polymère électriquement isolant, par détourage de la portion de câble haute tension autour de la direction d'extension principale du câble, au moins une portion du film étant utilisée lors de la formation de l'empilement multicouche.

Ainsi, l'assemblage pour l'étude du vieillissement est fabriqué à partir d'un câble haute tension réel. Le matériau étudié, présente un degré de représentativité maximal car la structure microstructurale, les éventuels additifs, l'histoire thermomécanique et l'état mécanique en fin de fabrication est celle d'un vrai câble, par exemple issu de son touret de transport. Par le détourage, le film formé est en outre représentatif du vieillissement du matériau d'intérêt à un endroit donné de la section transversale du câble haute tension. Il est donc possible d'étudier le vieillissement sur toute ou partie de la section transversale du ou des matériaux du câble, constitutifs du film.

En outre, ce procédé permet d'exposer la portion de câble à un vieillissement, ou d'étudier une portion de câble déjà vieillie par utilisation. Cela permet de mener des études du vieillissement dans des conditions se rapprochant d'autant plus de l'usure réelle d'un câble, et par exemple d'analyser les causes possibles en cas de rupture constatée du câble haute tension. Selon un exemple, le procédé comprend, avant la formation du film, un vieillissement du câble haute tension comprenant une exposition de la portion de câble à un courant électrique, et/ou dans lequel la portion de câble est issue d'un câble haute tension auparavant utilisé.

Selon un exemple, l'enroulement de l'empilement multicouche est effectué sous une atmosphère de taux d'humidité contrôlé et/ou de taux d'oxygène contrôlé. Ainsi, les conditions environnementales de vieillissement du câble peuvent être reproduites à l'échelle de l'assemblage au niveau de la couche de polymère isolant.

Selon un exemple, le procédé comprend la disposition de l'assemblage dans la capsule décrite dans le troisième aspect de l'invention.

Selon un exemple, la disposition de l'assemblage dans la capsule décrite dans le troisième aspect de l'invention est effectuée sous une atmosphère de taux d'humidité contrôlé. La disposition de l'assemblage dans la capsule peut être suivie de la fermeture étanche de la capsule.

Selon un exemple, le procédé comprend en outre, avant la formation de l'empilement multicouche, une sélection de la portion du film pour former l'empilement multicouche, selon la position correspondante du matériau à base de polymère isolant électriquement dans le câble haute tension. Il est ainsi possible d'analyser le vieillissement selon la localisation du matériau dans le câble, et par exemple de mener ces analyses pour des localisations distinctes radialement et/ou longitudinalement dans le câble.

Selon un exemple, le procédé comprend, avant la formation du film :
- un dressage d'un pourtour latéral de la portion de câble, et/ou
- un dressage d'au moins une, et de préférence de chaque, extrémité de la portion de câble.

Du fait des contraintes mécaniques s'exerçant à l'intérieur d'un câble haute tension, et notamment suite à une découpe pour obtenir la portion de câble, ces dressages permettent chacun de retrouver une surface de travail de meilleure qualité pour le détourage. Ainsi, les défauts induits par la découpe et non liés à la fabrication ou au vieillissement normal du câble peuvent être éliminés de l'assemblage obtenu.

Selon un exemple, la couche de polymère isolante est issue du détourage d'un câble haute tension.

L'assemblage peut être obtenu par le procédé selon le premier aspect.

Selon un exemple, au moins une parmi les première et deuxième couches d'électrodes dépasse au moins en partie de la première couche de polymère isolant et de la couche séparatrice selon la direction longitudinale. Le raccordement électrique de l'électrode est ainsi facilité sur la partie de l'électrode dépassant des autres couches.

De préférence, chacune parmi les première et deuxième couches d'électrodes dépasse de la première couche de polymère isolant et de la couche séparatrice selon la direction longitudinale, de sorte que la première couche d'électrode dépasse de la première couche de polymère isolant et de la couche séparatrice d'un premier côté de l'empilement par rapport à la direction longitudinale, de préférence sans dépasser sur un deuxième côté opposé au premier côté, et la deuxième couche d'électrode dépasse de la première couche de polymère isolant et de la couche séparatrice du deuxième côté de l'empilement, de préférence sans dépasser sur le premier côté,

Selon un exemple, les première et deuxième couches d'électrodes sont disposées de façon décalée de la première couche de polymère isolant et de la couche séparatrice selon la direction longitudinale, de sorte que :
- la première couche d'électrode dépasse de la première couche de polymère isolant et de la couche séparatrice d'un premier côté de l'empilement multicouche par rapport à la direction longitudinale, sans dépasser sur un deuxième côté de l'empilement multicouche opposé au premier côté,
- la deuxième couche d'électrode dépasse de la première couche de polymère isolant et de la couche séparatrice du deuxième côté de l'empilement multicouche, sans dépasser sur le premier côté.

Le raccordement électrique de chaque électrode est ainsi simplifié en conservant une configuration simple de l'assemblage. En outre, le décalage des couches d'électrodes permet que ces couches dépassent les autres sur une grande partie de leur longueur, et de préférence sur toute leur longueur. Le raccordement électrique sera donc encore simplifié. Ainsi, chacune des électrodes se retrouve exposée sur une des faces de l'enroulement, et plus particulièrement sur ces extrémités de part et d'autre de la direction longitudinale, lesquelles faces serviront au raccordement électrique accessible

Selon un exemple, la première couche de polymère isolant présente une épaisseur sensiblement comprise entre 50 µm et 200 µm, de préférence une épaisseur sensiblement comprise entre 70 µm et 150 µm, de préférence sensiblement égale à 100 µm. L'épaisseur de la couche de polymère isolant dans ces gammes est particulièrement adaptée pour réduire la tension à appliquer tout en conservant une force électromotrice représentative. Cette épaisseur est particulièrement avantageuse pour obtenir un vieillissement homogène dans l'épaisseur. Une épaisseur plus fine exacerbe la fragilité du matériau après vieillissement. Une épaisseur trop grande induit un vieillissement hétérogene, typiquement avec une couche oxydée de part et d'autre de la couche de polymère isolant. Avec 100 µm, on évite qu'une éventuelle porosité puisse trouer et fragiliser le film isolant.

Selon un exemple, la couche séparatrice est une couche à base d'un matériau électriquement isolant, et de préférence un polymère électriquement isolant.

Selon un exemple, la couche séparatrice est une deuxième couche à base du polymère électriquement isolant de câble de haute tension, dite deuxième couche de polymère isolant. De préférence, chaque couche de polymère isolant présente une épaisseur sensiblement comprise entre 50 µm et 200 µm, de préférence une épaisseur sensiblement comprise entre 70 µm et 150 µm, de préférence sensiblement égale à 100 µm.

Selon un exemple, la couche séparatrice est un adhésif. Selon un exemple, la couche séparatrice est un film issu d'un détourage différent.

Selon un exemple, la couche séparatrice est une couche à base d'un polymère choisi parmi le groupe constitué de polyimide (PI), polypropylène (PP), polyéthylène haute densité (PEHD), polyéthylène basse densité (PELD), polyéthylène réticulé (PEr), polyéthylène de masse molaire très élevée (UHMWPE), caoutchouc éthylène-propylène-diène monomère (EDPM), polyamide (PA), polyoxyméthylène (POM), polyétheréthercétone (PEEK), polyéthylènetéréphtalate (PET).

Selon un exemple, la couche séparatrice est une couche à base d'un polymère choisi parmi le groupe constitué de polyimide (PI). L'assemblage est ainsi particulièrement adapté pour des études de vieillissement à très haute tension, par exemple pour des tensions sensiblement égales à 10 000 V.

Selon un exemple, la couche séparatrice peut être issue du détourage d'une portion de câble distincte de la portion de câble dont est issue la couche de polymère isolant. Il est ainsi possible de faire vieillir deux échantillons de différents secteurs de câble dans des conditions identiques.

Selon un exemple, l'assemblage comprend un support interne autour duquel l'empilement multicouche est enroulé. De préférence, le support interne est électriquement isolant.

Selon un exemple, le corps de la cellule et les premier et deuxième bouchons sont configurés pour définir le volume intérieur clos de façon étanche. La capsule étanche conserve ainsi une atmosphère interne, de façon à adapter au besoin des conditions de vieillissement, et par exemple selon le taux d'humidité et/ou une présence ou non d'oxygène.

Selon un exemple, dans l'assemblage, au moins une parmi les première et deuxième couches d'électrodes dépasse au moins en partie de la première couche de polymère isolant et de la couche séparatrice selon la direction longitudinale, de façon à être en contact électrique avec l'électrode correspondante de la capsule, disposée en regard de ladite couche d'électrode. La capsule permet ainsi un raccordement électrique simplifié avec l'assemblage, en synergie avec le dépassement de la ou des électrodes de l'assemblage.

De préférence, chacune parmi les première et deuxième couches d'électrodes dépasse de la première couche de polymère isolant et de la couche séparatrice selon la direction longitudinale, de sorte que la première couche d'électrode dépasse de la première couche de polymère isolant et de la couche séparatrice d'un premier côté de l'empilement par rapport à la direction longitudinale, de préférence sans dépasser sur un deuxième côté opposé au premier côté, et la deuxième couche d'électrode dépasse de la première couche de polymère isolant et de la couche séparatrice du deuxième côté de l'empilement, de préférence sans dépasser sur le premier côté, de façon à être en contact électrique avec l'électrode correspondante, disposée en regard de ladite couche d'électrode.

Selon un exemple, au moins une et de préférence chaque électrode de la capsule est comprimée contre la couche d'électrode correspondante de l'assemblage, et contre le bouchon correspondant. Le raccordement électrique est fiabilisé. L'étude de vieillissement sera donc fiabilisée.

Selon un exemple, chaque bouchon est électriquement conducteur et est relié électriquement avec une électrode de la capsule, et dans laquelle le corps de la capsule est configuré pour isoler électriquement les premier et deuxième bouchons entre eux. Le raccordement électrique de la capsule à une source d'alimentation externe est ainsi facilité. En synergie avec les caractéristiques de dépassement des couches d'électrodes et/ou de la compression de la ou des électrodes de la capsule, on comprend que les raccordements électriques successifs sont fiabilisés.

Selon un exemple, le corps de la capsule comprend :
- un premier manchon électriquement isolant entourant latéralement l'assemblage,
- un deuxième manchon métallique entourant latéralement le premier manchon le deuxième manchon étant de préférence en contact électrique avec le deuxième bouchon, et
- une collerette électriquement isolante séparant le premier bouchon du deuxième manchon.

L'assemblage est ainsi isolé électriquement du corps de la capsule. Le deuxième manchon métallique améliore la conduction thermique de la capsule. Cela améliore donc la transmission d'une énergie thermique à l'assemblage lors d'une étude de vieillissement.

Selon un exemple, la capsule est configurée pour former une jonction étanche et amovible au niveau de la collerette. Par exemple, un premier joint d'étanchéité peut être disposé au niveau d'une zone de mise en butée du premier bouchon sur la collerette.

Par exemple, un deuxième joint d'étanchéité peut être disposé au niveau d'une zone de mise en butée du deuxième manchon sur la collerette.

Selon un exemple, le système comprend un nombre de cellules supérieur ou égale à 50, de préférence supérieur ou égale à 100.

Selon un exemple, le boitier comprend :
- un premier couvercle comprenant plusieurs connecteurs électriques, les connecteurs électriques étant configurés pour chacun connecter électriquement au moins une cellule, séparément de l'au moins une cellule connectée par les autres connecteurs électriques, et
- un deuxième couvercle configuré pour connecter électriquement ensemble les connecteurs électriques du premier couvercle à une source d'alimentation électrique externe.

Le premier couvercle permet d'analyser les propriétés électriques de chaque cellule, et donc de chaque assemblage, de façon différenciée. Comme une variabilité entre cellules peut être observée, une mesure pour chaque assemblage peut être faite. Il est en outre possible de faire des mesures in situ sans démonter l'ensemble du système. Ceci est d'autant plus avantageux compte-tenu de la durée des études de vieillissement, et donc du nombre de mesures à faire.

Le deuxième couvercle permet une parallélisation de l'alimentation électrique pour le vieillissement des assemblages, et simplifie le raccordement des cellules à la source d'alimentation externe. Le système est ainsi modulaire entre des phases de diagnostic et des phases de vieillissement, ce qui simplifie l'étude de vieillissement.

Selon un exemple, la cellule et/ou le système comprennent la source d'alimentation électrique externe.

Selon un exemple, le courant électrique présente une tension comprise entre 5 000 V et 20 000 V dans le procédé d'étude de vieillissement. Ces tensions permettent un vieillissement de l'assemblage pour évaluer le vieillissement d'un câble haute tension correspondant. En synergie avec l'épaisseur de la couche de polymère isolant, ces tensions permettent un vieillissement homogène et représentatif de la force électromotrice dans un câble haute tension en utilisation.

Dans la suite de la description, le terme « sur » ne signifie pas nécessairement « directement sur ». Ainsi, lorsque l'on indique qu'une pièce ou qu'un organe A est en appui « sur » une pièce ou un organe B, cela ne signifie pas que les pièces ou organes A et B soient nécessairement en contact direct avec l'autre. Ces pièces ou organes A et B peuvent être soit en contact direct soit être en appui l'une sur l'autre par l'intermédiaire d'une ou plusieurs autres pièces. Il en est de même pour d'autres expressions telles que par exemple l'expression « A agit sur B » qui peut signifier « A agit directement sur B » ou « A agit sur B par l'intermédiaire d'une ou plusieurs autres pièces ».

Dans la présente demande de brevet, lorsque l'on indique que deux pièces sont distinctes, cela signifie que ces pièces sont séparées. Elles peuvent être :
- positionnées à distances l'une de l'autre, et/ou
- mobiles l'une par rapport à l'autre et/ou
- solidaires l'une de l'autre en étant fixées par des éléments rapportés, cette fixation étant démontable ou non.

Une pièce unitaire monobloc ne peut donc pas être constituée de deux pièces distinctes.

Dans la présente demande de brevet, le terme « solidaire » utilisé pour qualifier la liaison entre deux pièces signifie que les deux pièces sont liées/fixées l'une par rapport à l'autre, selon tous les degrés de liberté, sauf s'il est explicitement spécifié différemment. Par exemple, s'il est indiqué que deux pièces sont solidaires en translation selon une direction X, cela signifie que les pièces peuvent être mobiles l'une par rapport à l'autre, possiblement selon plusieurs degrés de liberté, à l'exclusion de la liberté en translation selon la direction X. Autrement dit, si on déplace une pièce selon la direction X, l'autre pièce effectue le même déplacement.

Aux fins de la présente divulgation, l'expression "A et/ou B" signifie (A), (B), ou (A et B). Aux fins de la présente divulgation, l'expression "A, B et/ou C" signifie (A), (B), (C), (A et B), (A et C), (B et C), ou (A, B et C).

On entend par une couche, ou un matériau à base d'une espèce A, une couche, ou un matériau comprenant cette espèce A uniquement ou cette espèce A et éventuellement d'autres espèces, par exemple des additifs.

On entend par un paramètre « sensiblement égal/supérieur/inférieur à » une valeur donnée, que ce paramètre est égal/supérieur/inférieur à la valeur donnée, à plus ou moins 10 %, près de cette valeur. On entend par un paramètre « sensiblement compris entre » deux valeurs données que ce paramètre est au minimum égal à la plus petite valeur donnée, à plus ou moins 10 %, près de cette valeur, et au maximum égal à la plus grande valeur donnée, à plus ou moins 10 %, près de cette valeur.

Les différents aspects de l'invention sont maintenant décrits selon des exemples de réalisation en référence aux figures.

Comme l'illustrent les figures 2 à 7, un assemblage 2 est utilisé pour l'étude du vieillissement d'un câble électrique haute tension 1. On entend par câble électrique haute tension, ou de façon équivalente câble haute tension, un câble électrique configuré pour être traversé par une tension supérieure ou égale à 200 000 V, typiquement comprise entre 200 000 V et 500 000 V, par exemple 225 000 V et/ou 275 000 V. Un câble haute tension peut typiquement présenter une section transversale présentant une dimension supérieure ou égale à 80 mm. Dans la suite on utilise le terme « câble » pour désigner un câble haute tension.

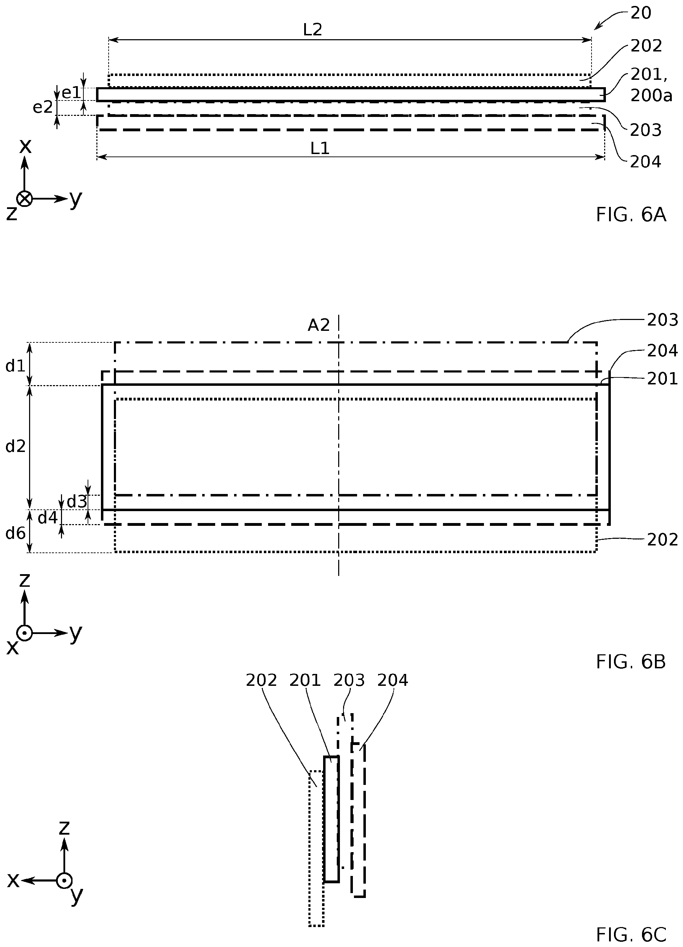

L'assemblage 2 est fabriqué par formation d'un empilement multicouche 20 comprenant une superposition au moins partielle de couches. Cette superposition comprend, en référence aux figures 6A à 7 :
- une première couche d'électrode 202, à base ou faite d'un matériau électriquement conducteur,
- une couche de polymère isolant 201 de câble de haute tension,
- une deuxième couche dite d'électrode 203, à base ou faite d'un matériau électriquement conducteur, et
- d'une couche séparatrice 204.

Cet empilement 20 est enroulé sur lui-même autour d'une direction d'enroulement A2, pour former une bobine de l'empilement multicouche présentant une direction longitudinale A2. Le terme longitudinal est plus particulièrement utilisé pour désigner la direction d'extension principale de l'assemblage, une fois enroulé. La direction A2 est ici plus particulièrement parallèle à la direction z De préférence, l'empilement multicouche 20 est entièrement enroulé sur lui-même selon la direction de la longueur des couches de l'empilement. Selon un exemple, l'empilement multicouche 20 enroulé sur lui-même comprend uniquement les couches précitées, c'est-à-dire sans couche additionnelle incluse dans l'empilement.

La couche de polymère isolant, aussi désignée première couche de polymère isolant 201, est disposée entre les première 202 et deuxième 203 couches d'électrodes. Ainsi, la couche de polymère isolant 201 peut être exposée à un courant électrique alternatif ou continu, de façon à simuler un vieillissement accéléré de ce matériau, dans le cadre d'une étude de vieillissement d'un câble haute tension 1.

La couche séparatrice 204 est configurée pour isoler électriquement entre elles les première 202 et deuxième 203 couches d'électrodes. La couche séparatrice 204 est pour cela au moins en partie superposée avec l'ensemble formé par les première 202 et deuxième 203 couches d'électrodes et la première couche de polymère isolant 201. La couche séparatrice 204 peut plus particulièrement être disposée en dessous ou en dessus de l'ensemble formé par les première 202 et deuxième 203 couches d'électrodes et la première couche de polymère isolant 201. Une fois l'empilement multicouche 20 enroulé, la couche séparatrice 204 est disposée entre les première 202 et deuxième 203 couches d'électrodes de façon à les isoler électriquement.

Pour fabriquer cet assemblage 2, comme illustré par la figure 2, une portion 10 de câble 1 peut être fournie. Ainsi, l'assemblage 2 est fabriqué à partir d'un câble haute tension réel. Comme illustré par la figure 1, cette portion 10 peut comprendre dans sa section transversale une âme 11 entourée d'une gaine semi-conductrice interne 12, elle-même entourée d'un matériau isolant 13 à base d'un polymère électriquement isolant. L'âme 11 peut comprendre des fils métalliques 110, par exemple tressés entre eux. Le matériau isolant 13 peut être entouré d'une gaine semi-conductrice externe 14, entourée d'un blindage électromagnétique 15 puis d'une gaine extérieure 16 isolante électriquement.

La portion 10 peut être découpée à partir d'un câble 1, par exemple par tronçonnage. Cette opération de découpe peut engendrer de nombreux défauts aux extrémités 10a et 10b. Ces défauts peuvent s'expliquer par les contraintes internes dans le câble 1. Ces contraintes internes peuvent notamment entraîner un retrait du matériau diélectrique 13 selon la direction d'extension principale A1 de la portion 10 de câble 1. En outre, les défauts liés à l'opération de découpe, tels que des particules métalliques ou des déchets de gaine, peuvent être observés.

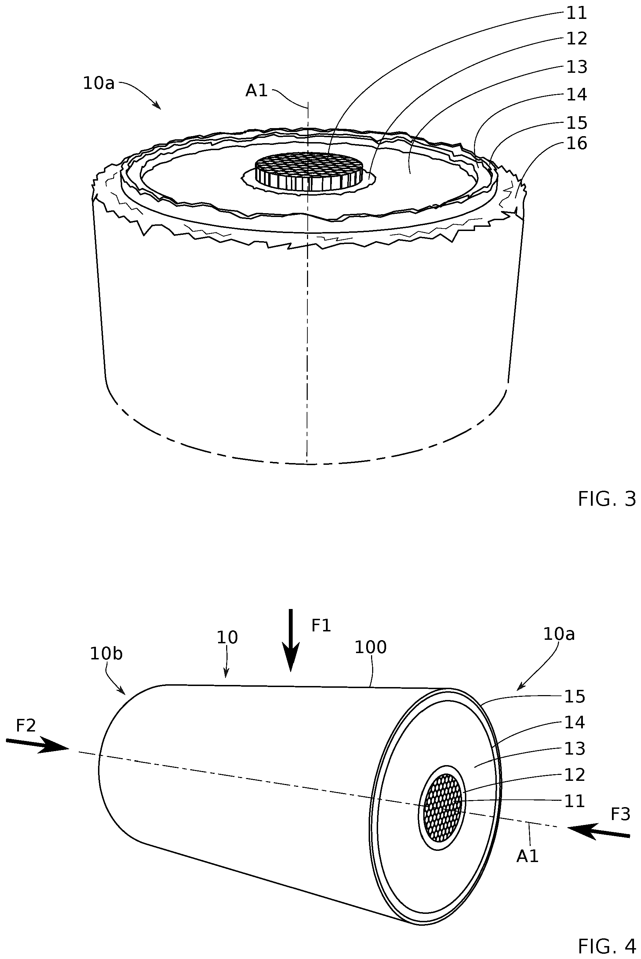

Afin d'éliminer ces défauts, et comme illustré en figure 4 par exemple, le procédé peut comprendre un dressage de la portion 10 de câble. Un dressage du pourtour latéral 100 de la portion 10 de câble 10 peut être réalisé, par exemple selon la flèche F1. Ce dressage peut être configuré de façon à retirer les éléments du câble 1 jusqu'au blindage électromagnétique 15, et notamment la gaine extérieure isolante 16. Ainsi, on retrouve une cylindricité de la circonférence du câble 1. Un dressage peut être réalisé au niveau d'au moins une et de préférence à chaque extrémité 10a, 10b de la portion 10 de câble 1, par exemple selon les flèches F2 et F3. Ce dressage de préférence faite de façon à aplanir la section transversale au niveau de l'extrémité 10a, 10b, de préférence jusqu'à corriger le retrait du matériau isolant. Ceci permet de corriger des défauts liés au tronçonnage et liés aux contraintes internes dans le câble 1. Ces dressages peuvent être effectués au tour conventionnel.

Ces étapes de découpe et/ou de dressage peuvent entraîner de nombreux débris et poussières, qui peuvent impacter le comportement de l'assemblage 2 lors de l'étude de vieillissement, et par exemple induire un claquage du polymère isolant de la première couche 201. Les données recueillies lors de l'étude de vieillissement peuvent donc être impactées. Le procédé peut comprendre un ou des nettoyages afin d'éviter les contaminations métalliques et plastiques. Ce ou ces nettoyages peuvent être à l'air comprimé, de type mécanique (par exemple la brosse, par ultrason), en milieu liquide, ou un mélange de ces conditions (par exemple en bain à ultrason).

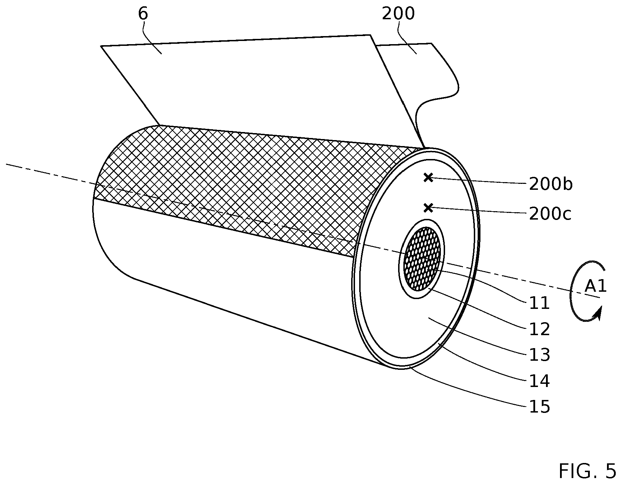

Un film 200 peut ensuite être formé par détourage de la portion 10 de câble 1 autour de la direction d'extension principale A1 de la portion 10 de câble 1. Comme illustré par exemple par la figure 5, une lame 6 peut venir découper un film 200 par rotation relative entre la lame 6 et la portion 10 de câble 1 autour de l'axe A1, et notamment par rotation de la portion 10 de câble 1. Cette opération peut être faite par un appareil conventionnel de tournage. L'opération de détourage peut être faite depuis le blindage électromagnétique 15 jusqu'à la gaine semi-conductrice interne 12. Selon notre exemple, le blindage électromagnétique 15 peut être retiré avant l'opération de détourage, le détourage étant alors effectué depuis la gaine semi-conductrice externe 14. Le blindage peut être retiré par une opération de tournage sur le pourtour extérieur de la portion 10 de câble. Cette opération permet en outre de rattraper la cylindricité de la portion 10 souvent courbée par l'enroulement du câble sur le touret. Selon la position du tronçon de câble sur le touret, la courbure est plus ou moins prononcée.

Il est envisageable de détourer aussi la gaine semi-conductrice interne 12. Pour cela, il est possible d'usiner complètement l'âme métallique 11 pour retirer tous les éléments métalliques de la portion 10 de câble, nettoyage pour éliminer toutes les contaminations métalliques. Il serait ensuite possible de boucher le trou laissé par l'âme 11 par un noyau en polymère isolant (du polyéthylène par exemple), par exemple emmanché en force pour pouvoir finalement faire le détourage jusque dans le semi-conducteur de la gaine interne et même au-delà jusque dans le noyau en polymère isolant pour récupérer totalement le semi-conducteur interne.

L'opération de détourage peut par exemple produire une longueur de film 200 supérieure ou égale à 10 m, de préférence supérieure ou égale à 20 m, et plus préférentiellement encore sensiblement égale à 30 m. Le film 200 peut comprendre une partie à base ou faite du polymère électriquement isolant, et une partie à base ou faite du semi-conducteur de gaine externe 14. La partie à base ou faite du semi-conducteur de gaine externe 14 peut présenter une longueur supérieure ou égale à 1 m, par exemple sensiblement égale à 1,5 m.

Seulement une portion 200a du film 200 peut être utilisée pour former l'empilement multicouche 20. Le procédé peut donc comprendre une découpe de cette portion 200a à partir du film 200. Cette portion 200a peut être sélectionnée dans le film 200 en fonction de sa localisation correspondante dans le câble 1, par exemple les localisations 200b ou 200c illustrées en figure 5.

Notons que le film 200 obtenu par détourage présente des rayures (traces de l'arrête de coupe) sur le fil, provenant de la vibration lors de la découpe. Sous lumière polarisée, il est possible d'observer par biréfringence des déformations locales liées à la découpe. Sur un film extrudé, la surface est lisse et exempte de déformations locales

À partir d'un film 200, on comprend donc que plusieurs assemblages 2 peuvent être fabriqués. Le procédé permet donc de fabriquer, de façon simplifiée par rapport aux solutions existantes, plusieurs assemblages 2. Il est ainsi possible d'avoir plus de données pour l'étude du vieillissement et donc plus de statistiques disponibles. Comme vu ci-dessus, ces données peuvent par exemple prendre en compte la localisation radiale du matériau isolant 13 dans le câble 1. Il est possible en outre de prévoir que la portion 10 de câble 1 soit choisie en fonction de la localisation de la portion 10 dans le câble 1. Encore plus de données statistiques pourront être obtenues de l'étude.

Préalablement à la formation du film 200, le procédé peut comprendre un vieillissement de la portion 10 de câble 1, par exemple en l'exposant à des conditions électriques, mécaniques et/ou thermiques données, décrites en exemple ultérieurement. Du fait de l'utilisation d'une portion 10 seulement de câble 1, et non d'un câble haute tension entier, il est en effet possible de soumettre cette portion à un vieillissement pour étudier son impact sur la structure des matériaux au plus proche des conditions réelles. En alternative en complément, on peut prévoir d'utiliser une portion 10 venant d'un câble 1 déjà utilisé pour de l'alimentation électrique haute tension, déjà vieilli naturellement en conditions réelles d'exploitation, par exemple dans une zone particulièrement sollicitée du réseau électrique.

La portion 200a va ainsi former la première couche de polymère isolant 201 de l'empilement multicouche 20. L'empilement multicouche 20 est désormais décrit plus en détail en référence figure 6A à 6C.

Chaque couche de l'empilement 20 présente une longueur et une largeur, la longueur suivant la direction y étant supérieure à la largeur selon la direction z. La direction longitudinale d'enroulement A2 peut être sensiblement perpendiculaire à la direction de la longueur de chaque couche.

Les différentes couches de l'empilement 20 peuvent être disposées entre elles de façon à faciliter le raccordement électrique des couches d'électrodes 202, 203.

Pour cela, et comme illustré par les figures 6A à 6C, les couches de l'empilement multicouche 20 peuvent être décalées entre elles. Plus particulièrement, chaque couche d'électrode 202, 203 peut dépasser de la première couche de polymère isolant 201 et la couche séparatrice 204 selon la direction d'enroulement A2. La première couche d'électrode 202 peut dépasser d'un premier côté de l'empilement multicouche 20. La deuxième couche d'électrode 203 peut dépasser de l'autre côté de l'empilement multicouche 20 de façon opposée au premier côté. Des portions de contact 202a, 203a sont ainsi formées.

De préférence, au moins une, et de préférence chacune, parmi les première et deuxième couches d'électrodes 202, 203 dépasse de la première couche de polymère isolant et de la couche séparatrice selon la direction longitudinale, sur sensiblement au moins 80 %de leur longueur et de préférence sur toute leur longueur.

En alternative ou en complément à un décalage des couches d'électrodes, on peut prévoir que les couches d'électrodes comprennent au moins une et de préférences plusieurs pattes qui dépassent de la première couche de polymère isolant 201 et la couche séparatrice 204 selon la direction d'enroulement A2.

Selon un exemple, les bords des longueurs des couches d'électrodes 202, 203 dépassent des bords des longueurs de la première couche de polymère isolant 201 d'une distance d1, d6 sensiblement supérieure à 5 mm, de préférence sensiblement supérieure ou égale à 10 mm.

Les différentes couches de l'empilement 20 peuvent être disposées entre elles de façon à limiter le risque de contact entre les couches d'électrodes 202 et 203, et ainsi éviter un court-circuit lors de l'application d'un courant électrique. Par exemple, la couche d'électrodes dépassant d'un côté de l'empilement multicouche 20 peut être placée en retrait de la couche séparatrice 204 et/ou de la première couche de polymère isolant 201 de l'autre côté, comme illustré par exemple figure 6B. Ce retrait peut correspondre à la distance d3 et être supérieur ou égal à 5 mm

Pour cela, la longueur L1 selon la direction Y de la première couche de polymère isolant 201 et de la couche séparatrice 204 peut être supérieur strictement à la longueur L2 des couches d'électrodes 202, 203. Le risque d'un contact entre les couches d'électrodes 202, 203 une fois l'empilement multicouche 20 enroulé est ainsi réduit. Par exemple, la différence L1-L2 peut être supérieure ou égale à 10 mm de préférence supérieure ou égale à 20 mm. La longueur maximale des couches de l'empilement multicouche 20 peut être supérieure ou égale à 50 cm, de préférence supérieure ou égale à 70 cm.

Par exemple, la largeur d2 de la première couche de polymère isolant 201 peut être supérieure ou égale à 40 mm, de préférence supérieure ou égale à 50 mm. La couche séparatrice 204 peut en outre présenter au moins une distance d4 strictement supérieure à la distance prise sur la même direction de la première couche de polymère isolant 200, par exemple d4 est supérieur ou égal à 5 mm.

L'assemblage peut être sous une sous tension mécanique déterminée pour être dans un état d'étirage fixé, par exemple compris entre 1% et 5 % (soit 1%, 2% ou 5% par exemple), de manière à reproduire l'état de contrainte axiale réelle du câble comme peut l'être le câble réel, ou lorsque le câble se dilate pendant le fonctionnement (la dilatation du cœur du câble produit une contrainte axiale de traction via les effets de Poisson du matériau isolant). Le cœur du câble peut en effet atteindre 90°C.

La longueur de la couche séparatrice 204 peut être plus grande que la longueur de la couche isolante L1 surtout si la couche séparatrice est un adhésif polyimide. Cela permet de garder l'état de tension mécanique de l'enroulement

Les différentes couches de l'empilement multicouche 20 sont maintenant décrites plus en détail.

La première couche de polymère isolant 201 est à base ou faite d'un polymère électriquement isolant utilisé comme matériau isolant dans les câbles haute tension. Ce polymère peut être un polymère de la famille des thermoplastiques extrudables et isolant, par exemple du polyéthylène PE, polypropylène (PP), polyéthylène haute densité (PEHD), polyéthylène basse densité (PELD), polyéthylène réticulé (PEr), caoutchouc éthylène-propylène-diène monomère (EDPM), polyoxyméthylène (POM), et notamment selon la composition du câble 1 dont on cherche étudier le vieillissement. De préférence, ce polymère présente :
- un module Young compris entre 80 MPa à 200 MPa, et/ou
- des seuils à l'écoulement inférieur à 20 MPa, et/ou
- des déformations à rupture supérieures à 500%.

Le polymère est ainsi particulièrement adapté à former un film 200 par l'opération de détourage.

La couche de polymère isolant comprend au moins une portion à base d'un polymère électriquement isolant de câble de haute tension. Elle peut comprendre une deuxième portion à base d'un matériau semi-conducteur de gaine. L'assemblage étudié peut en effet comprendre du semi-conducteur de gaine, la tension électrique appliquée lors du vieillissement pouvant être adaptée pour cela.

La couche séparatrice 204 peut être une deuxième couche de polymère isolant, par exemple issu du même film 200. Ainsi, une même opération de détourage forme les couches intercalaires aux couches d'électrodes 202, 203. Selon un autre exemple, la couche séparatrice 204 est une couche à base ou faite d'un polymère distinct du polymère de la couche 201. De préférence, la couche séparatrice 204 est à base ou faite de polyimide. Pour des études très haute tension (typiquement pour des tension supérieures ou égales à 100 kV), l'isolant devrait être plus épais que 100µm pour éviter le claquage. Pour éviter aussi d'augmenter l'épaisseur du séparateur, un matériau haute performance diélectrique est préférable. Le polyimide est un matériau haute performance, présentant une haute permittivité électrique relative supérieure à 3.

La première couche de polymère isolant 201 et/ou la couche séparatrice 204, de préférence chacune de ces couches, présente une épaisseur e1, prise selon la direction X en référence à la figure 6A, sensiblement comprise entre 50 µm et 200 µm, de préférence une épaisseur sensiblement comprise entre 70 µm et 150 µm, de préférence sensiblement égale à 100 µm. Ces épaisseurs sont particulièrement adaptées pour réduire la tension à appliquer tout en conservant une force électromotrice représentative. Plus particulièrement, la tension appliquée à l'assemblage pour l'étude de vieillissement alors être comprise entre 700 V et 20 000 V, par exemple supérieure à 5 000 V et/ou inférieure à 17 000 V.

Par exemple, l'épaisseur de l'isolant du câble de 225 000 V est de 20 mm, ce qui fait une force électromotrice E = 11 250 000 V/m. Cette force électromotrice est la force non accélérée. En conservant cette même force électromotrice correspondant à la situation réelle du cable, si on prend un isolant de 70 µm d'épaisseur, il faudra appliquer 787,5 V pour avoir la même force E. Pour 100 µm d'épaisseur, 1 125 V et pour 150µm, 1687,5 V. Pour l'essai de vieillissement, il y a un facteur d'accélération qui dépendra de la haute tension retenue pour l'étude de vieillissement, typiquement 10 000 V. Avec un facteur 10 d'accélération, on arrive à 16 875 V pour un film de 150µm.

Les couches d'électrodes 202, 203 peuvent être en métal, et de préférence en aluminium. Ces couches peuvent présenter une épaisseur a2, prise selon la direction X en référence à la figure 6A, sensiblement comprise entre 10 µm et 20 µm.

Lorsque la couche de polymère isolant est mise sous tension mécanique, de préférence l'assemblage avant enroulement est aussi sous tension mécanique. Pour cela, il peut être déposé sur la face en contact avec la couche de polymère isolant un adhésif par spray amovible du type adhésif post-it pour permettre de générer une tension mécanique dans les électrodes et à la fois un glissement possible pour éviter la déchirure des couches d'électrodes.

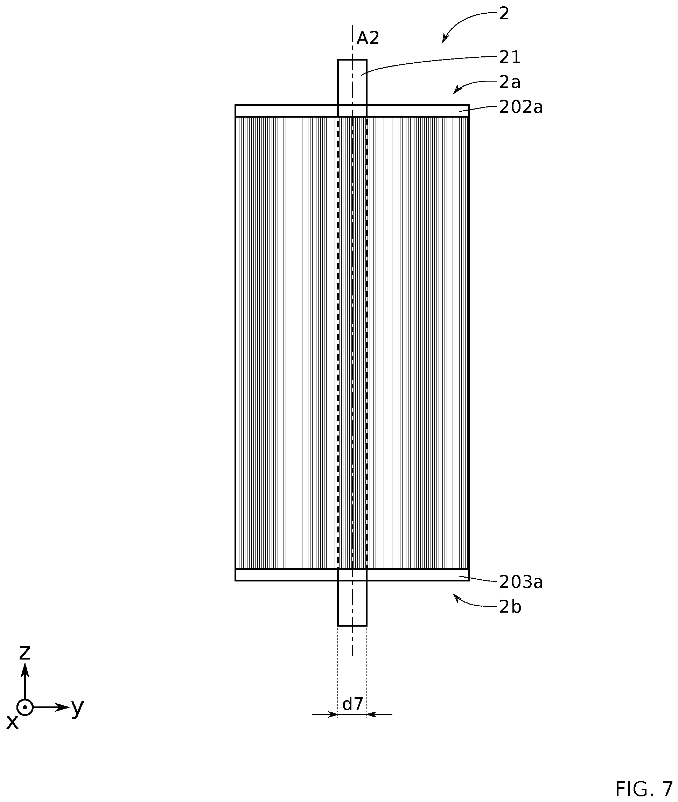

L'empilement multicouche 20 est enroulé sur lui-même autour de la direction A2 pour obtenir l'assemblage 2 par exemple illustré en figure 7. L'assemblage 2 peut comprendre au moins deux tours, et de préférence au moins cinq tours de l'empilement multicouche 20. Cela va par exemple dépendre du diamètre du support isolant 21. Le support isolant peut être un tube en polypropylène, par exemple de diamètre 16 mm. Après enroulement, l'assemblage peut présenter un diamètre d'environ 25 mm, soit 6 empilements. L'idée est de minimiser le nombre d'empilement pour limiter les défauts d'enroulement qui pourraient faire vieillir prématurément les capsules

Cet enroulement peut être fait sur une bobineuse, par exemple semi-automatique, et de préférence une bobineuse capable de gérer la tension mécanique de la couche isolante de plusieurs pourcents de déformation (de déformation comprise entre 1% à 10%). L'empilement comprenant la couche de polymère isolant peut en effet être mis sous tension pour reproduire l'état de contrainte axiale du câble. Le processus de mise sous tension peut être fait par un poids ou un tendeur à rouleau dans le cas où l'enroulage se fait sur un banc à rouleaux.

De préférence l'enroulement est configuré pour respecter le sens intérieur/extérieur de la portion 200a dans le câble 1 initial. L'extrémité de la portion 200a étant originellement disposée vers l'intérieur de l'assemblage 2, sera ainsi enroulée en premier pour être disposée à l'intérieur de l'assemblage 2. L'étude de vieillissement sera d'autant plus représentative du câble 1 originel.

Lors de l'enroulement du câble, l'empilement multicouche 20 peut être exposé à des conditions correspondant aux conditions d'étude de vieillissement souhaitées. Par exemple, lors de l'enroulement, l'atmosphère peut être contrôlée. Le taux d'humidité et/ou la présence d'oxygène peuvent être contrôlés. Par exemple, une atmosphère anhydre peut être utilisée pour respecter les conditions enterrées de câble haute tension. Une atmosphère sans oxygène mais avec un taux d'humidité important pourrait être utilisé pour mimer des conditions sous-marines de câble haute tension. Pour mimer des conditions de câble enterré, l'atmosphère sera inerte (par exemple sous argon) avec un taux d'humidité. Pour mimer des conditions de câble aérien, l'atmosphère sera de l'air comprenant de l'humidité.

L'assemblage 2 peut en outre comprendre un support 21, par exemple un support électriquement isolant. Ce support peut permettre l'enroulement de l'empilement multicouche 20, ainsi que sa manipulation le support 21 peut présenter une dimension d7 transversale, par exemple un diamètre, pris selon la direction Y en référence à la figure 7, supérieure ou égale à 15 mm, de préférence sensiblement égale à 16 mm.

Selon un exemple, l'assemblage 2 présente un diamètre, pris selon la direction Y en référence à la figure 7, supérieur ou égal à 20 mm, de préférence sensiblement égale à 24 mm.

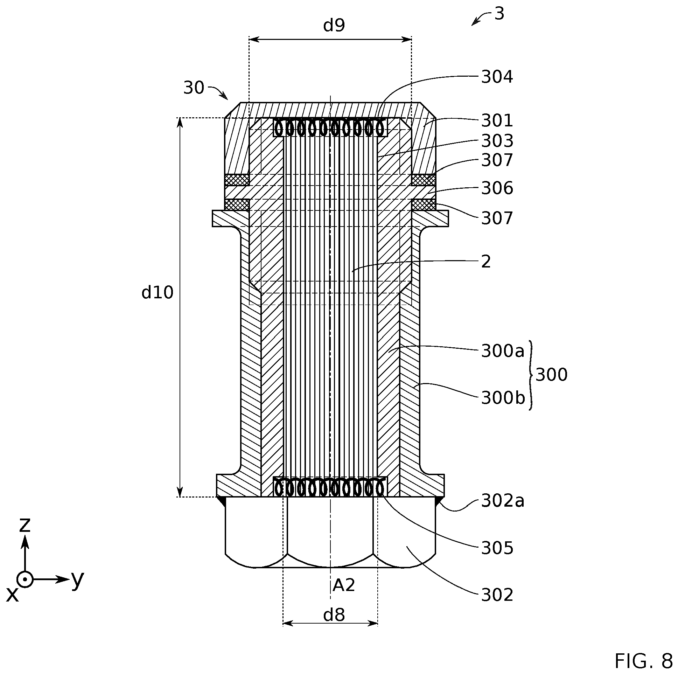

Comme illustré par exemple en figure 8, l'assemblage 2 peut être disposé dans une capsule 30 configurée pour alimenter électriquement l'assemblage 2. On obtient ainsi une cellule 3. Pour cela, la capsule 30 comprend un corps 301, un premier bouchon 301 et un deuxième bouchon. Ces éléments définissent un volume intérieur clos 303 dans lequel l'assemblage 2 est reçu.

La capsule 30 est maintenant décrite plus en détail en référence à la figure 8.

À l'intérieur du volume clos 303, deux électrodes 304, 305 peuvent être disposées de façon à raccorder chacune une couche d'électrode 202, 203 distincte de l'assemblage 2. La capsule 30 peut être configurée de façon à mettre en contact électriquement les deux électrodes 304, 305 avec une source d'alimentation électrique externe. Selon un exemple, des électrodes 303, 304 sont disposées de part et d'autre du volume intérieur 303 selon la direction Z, ou de façon équivalente selon la direction d'enroulement A2 de l'assemblage 2. Chaque électrode peut être configurée pour être compressée contre les extrémités 2a, 2b de l'assemblage 2, illustrées en figure 7, et plus particulièrement les portions de contact 202a, 203a. Les électrodes 304, 305 sont par exemple en aluminium.

Chaque bouchon 301, 302 peut être électriquement conducteur, par exemple en métal, et en contact électrique, de préférence en contact direct, avec l'électrode 304, 305 correspondante. La reprise de contact au niveau de la capsule 30 est ainsi facilitée. Les bouchons 301, 302 peuvent être en acier inoxydable, ou de préférence à base ou faits de cuivre ou d'alliage de cuivre (par exemple de laiton).

Le corps 300 de la capsule 30 peut comprendre un premier manchon 300a électriquement isolant et entourant latéralement l'assemblage 2 dans le plan (x,y). De préférence, le premier manchon s'étend selon la direction Z sur une longueur d10 sensiblement égales à l'ensemble formé par les électrodes 304, 305 et l'assemblage 2. d10 peut être supérieurs ou égal à 60 mm, de préférence sensiblement égale à 66 mm. Le premier manchon 300a peut présenter une dimension transversale prise selon la direction Y en référence à la figure 8, par exemple un diamètre intérieur, supérieur ou égal à 20 mm, de préférence sensiblement égale à 26 mm

Le corps 300 de la capsule 30 peut comprendre en outre un deuxième manchon 300b, par exemple métallique, entourant latéralement le premier manchon 300a. Le deuxième manchon 300b peut s'étendre les premier et deuxième bouchons 301, 302/ Selon un exemple, le deuxième manchon 300b est en contact électrique avec le deuxième bouchon 302. De préférence, le deuxième manchon 300b est en cuivre. La conduction thermique par le deuxième manchon 300b est ainsi améliorée. L'exposition de l'assemblage 2 à une contrainte thermique est ainsi améliorée lors de l'étude du vieillissement.

Le corps 300 de la capsule 30 peut en outre comprendre une collerette 306 électriquement isolante et configurée pour séparer le premier bouchon 301 du deuxième manchon 300b. La collerette 306 peut être disposée autour du premier manchon 300a. La collerette 306 et le premier manchon 300a peuvent par exemple former un ensemble monobloc.

Le premier manchon 300a et la collerette 306 peuvent être à base ou fait d'un polymère électriquement isolant, de préférence de polyétheréthercétone (communément désigné par PEEK de l'anglais PolyEtherEtherKeton).

De préférence, la capsule 30 est configurée pour définir le volume intérieur clos 303 de façon étanche. L'assemblage 2 peut ainsi être placé sous atmosphère contrôlée, comme décrit précédemment, dans la capsule 30 afin de conserver les conditions souhaitées pour l'étude du vieillissement.

Pour cela, le deuxième bouchon 302 peut être solidarisé au corps 300, et plus particulièrement au deuxième manchon 300b, par brasure. Le premier bouchon 301 peut coopérer avec le corps 300, et plus particulièrement le premier manchon 300a, par vissage avec des filetages complémentaires.

Le premier bouchon 300 peut donc être vissé sur le corps 300 jusqu'à obtenir une jonction étanche pour refermer le volume clos 303. Pour cela, un ou des joints 307, par exemple des joints annulaires, peuvent être disposés au niveau de la collerette 306. Les joints 307 peuvent être disposés de part et d'autre de la collerette 306 selon la direction Z. Ainsi, le premier bouchon 301 vient en butée contre un joint d'étanchéité 307 et vient pousser la collerette 306 contre le deuxième manchon 300b par le biais d'un deuxième joint d'étanchéité 307.

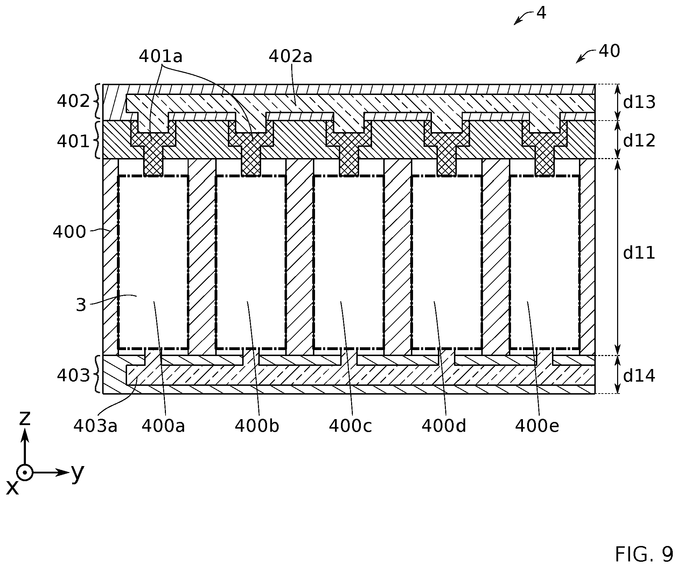

Une ou de préférence plusieurs cellules 3 peuvent être disposées dans un boîtier 40 pour former un système 4. Le boîtier 40 est maintenant décrit plus en détail en référence à la figure 9. Le boîtier 40 est configuré pour alimenter électriquement les cellules 3.

Pour cela, le boîtier 40 peut comprendre un corps 400 comprenant au moins un et de préférence plusieurs logements 400a, 400b, 400c, 400d, 400e. Chaque logement peut être configuré pour accueillir une cellule 3, et de préférence une unique cellule 3. Le corps 400 peut être à base ou fait d'un matériau électriquement isolant. Selon un exemple, le corps 400 est en bakélite. Ainsi, le corps est électriquement isolant et résiste à la chaleur. Ceci est donc particulièrement avantageux pour l'étude du vieillissement d'un câble 1 sous contrainte thermique.

Le boîtier 40 peut être configuré pour accueillir un nombre de cellules 3 supérieur ou égal à 50, et de préférence supérieure ou égale à 100. Selon un exemple, le corps 400 forme une matrice de logements pour accueillir les cellules 3, par exemple une matrice 10 x 10. Le système 4 permet ainsi l'étude d'un grand nombre d'assemblages 2 en parallèle.

Le boîtier 40 peut comprendre en outre au moins un couvercle configuré pour connecter électriquement les cellules 3 à une sorte d'alimentation électrique externe 5.

Le boîtier 40 peut comprendre un premier couvercle 401 configuré pour connecter électriquement chaque cellule 3 de façon isolée par rapport aux autres cellules 3. Ainsi, les propriétés électriques de chaque cellule 3 peuvent être testées pour chaque cellule 3 individuellement. Pour cela, le premier couvercle 401 peut comprendre plusieurs connecteurs électriques 401a. Chaque collecteur électrique 401a peut être configuré pour former une connexion électrique pour une cellule 3 donnée. Dans le couvercle 401, les connecteurs électriques 401a ne sont pas reliés électriquement entre aux. Les connecteurs électriques 401a peuvent être séparés les uns des autres par un matériau électriquement isolant, par exemple en bakélite.

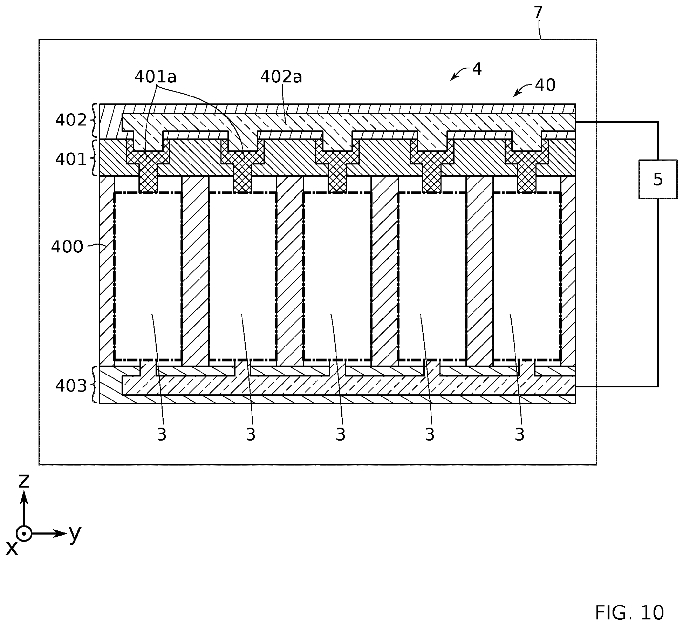

Le boîtier 40 comprendre un deuxième couvercle 402 configuré pour connecter les connecteurs électriques 401a du premier couvercle 401 à la source d'alimentation électrique 5 externe, par exemple illustrée en figure 10. Le deuxième couvercle 402 permet ainsi une reprise de contact au niveau des connecteurs 401a du premier couvercle 401 et une mise en parallèle des cellules 3. Pour cela, le deuxième couvercle 402 peut comprendre un connecteur électrique 402a configuré pour connecter ensemble électriquement les connecteurs 401a du premier couvercle 401. Le connecteur électrique 402a peut être configuré pour être connecté électriquement à la source d'alimentation électrique 5 externe. Hormis pour ses parties en contact avec les connecteurs électriques 401a et la portion de connexion à la source d'alimentation externe 5, le connecteur électrique 402a peut être isolé de son environnement électriquement par un matériau électriquement isolant, par exemple de la bakélite.

Le boîtier 40 peut en outre comprendre un fond 403 configuré pour relier électriquement chaque cellule 3 de façon à refermer le circuit électrique avec la source d'alimentation externe 5. Pour cela, le fond 403 peut comprendre un connecteur électrique 403a configuré pour connecter ensemble électriquement les cellules 3. Le connecteur électrique 403a peut être configuré pour être connecté électriquement à la source d'alimentation électrique 5 externe. Hormis pour ses parties en contact avec les cellules 3, le connecteur électrique 403a peut être isolé de son environnement électriquement par un matériau électriquement isolant, par exemple de la bakélite.

Les connecteurs électriques 401a, 402a, 403a du boitier 40 sont de préférence en cuivre.

Quelques dimensions du boitier 40 sont maintenant données. d11 est de préférence supérieure ou égale à la hauteur d'une cellule selon la direction z, et de préférence sensiblement égale à 100 mm. d12, d13 et d14 peuvent être égales, par exemple sensiblement égales à 15 mm. Le boitier peut présenter une largeur en y et une profondeur en x sensiblement égale à 400 mm. Les logements 400a, 400b... peuvent être espacés d'une distance selon x et/ou y sensiblement égale à 10 mm.

Le procédé d'étude du vieillissement d'un câble haute tension 1 et maintenant décrit. Ce procédé peut mettre en œuvre les différents objets décrits précédemment. Plus particulièrement, le procédé peut comprendre une exposition d'au moins un assemblage 2 à un courant électrique, et de préférence de plusieurs assemblages 2. Le courant électrique peut être alternatif ou continu selon les types de câble haute tension 1 et/ou selon les conditions de vieillissement souhaitées. Le courant électrique peut présenter une tension comprise entre 5 000 V et 20 000 V de préférence entre 10 000 V et 20 000 V. La source d'alimentation électrique 5 externe peut être configurée pour générer ce courant. Selon un exemple, la source d'alimentation électrique 5 est un générateur de haute tension. Ce courant électrique peut être amené jusqu'à l'assemblage 2 par le biais du système 4 et des différents connecteurs électriques reliant la source d'alimentation externe 5 à la cellule 3 et donc l'assemblage 2. La source d'énergie électrique 5 externe et l'enceinte terme régulée peuvent faire partie du système 4.

Outre l'exposition à un courant électrique, le procédé d'étude peut comprendre l'exposition des assemblages 2 à une contrainte thermique, et par exemple une température supérieure ou égale à 60°C, et/ou des contraintes mécaniques. Pour cela, le système 4 peut être disposé dans une enceinte 7 régulée thermiquement, comme l'illustre la figure 10. Le choix de la température dépend de la durée de l'étude. Car plus elle est basse plus l'accélération est faible et donc plus le vieillissement est lent. 60°C est la température minimale pour le matériaux isolant du câble, car c'est la température où il y a une transition mécanique qui favorise la mobilité macromoléculaire dans le matériaux isolant (donc cela accélère la diffusion et les réactions chimiques du vieillissement). Cette température d'étude reste de préférence inférieure à la température de fusion du polymère d'intérêt

Pour étudier le vieillissement des assemblages 2, le procédé peut comprendre au moins une mesure d'une propriété électrique, et notamment de la résistance interne, des assemblages 2. Pour cela, dans le système 4, le deuxième couvercle 402 du boîtier 40 peut être retiré. La résistance interne d'un assemblage 2 peut être mesurée par le biais du connecteur 401a correspondant. La variabilité entre les différentes cellules 3 peut donc être analysée *in situ* en minimisant les manipulations des assemblages 3.

Le procédé d'étude peut comprendre l'étude d'un nombre d'assemblages 2 supérieur ou égal à 50 et de préférence supérieur ou égal à 100. Ceci est particulièrement avantageux compte tenu de la durée des études vieillissement qui peuvent par exemple durer jusqu'à cinq ans. Dans une même étude, des conditions d'étude peuvent être différentes entre différentes cellules 3, par exemple le taux d'humidité et/ou la présence d'oxygène ou non. Les capsules 30 étanches sont particulièrement avantageuses à cette fin. L'étude du vieillissement peut donc prendre en compte un plus grand nombre de variables pour la prédiction de la durée de vie du câble haute tension. Dans une même étude, plusieurs assemblages 2 issus d'un même câble haute tension peuvent être étudiés sous les mêmes conditions. Cela permet d'améliorer la statistique de l'étude et donc d'améliorer la visibilité du résultat. Dans le boitier 40, plusieurs assemblages 2 issus de différents câbles haute tension peuvent être étudiés, sous les mêmes conditions d'atmosphère ou non.

L'invention est définie par les revendications annexées.

## Revendications

1. Procédé de fabrication d'un assemblage (2) pour étude du vieillissement d'un câble haute tension (1), le procédé comprenant :
• une formation d'un empilement multicouche (20) comprenant la superposition au moins partielle :
∘ d'une première couche dite d'électrode (202), à base d'un matériau électriquement conducteur,
∘ d'au moins une couche à base d'un polymère électriquement isolant, dite première couche de polymère isolant (201),
∘ d'une deuxième couche dite d'électrode (203), à base d'un matériau électriquement conducteur, de sorte que la première couche de polymère isolant (201) est disposée entre les première (202) et deuxième (203) couches d'électrodes, et
∘ d'une couche séparatrice (204) au moins en partie superposée avec l'ensemble formé par les première (202) et deuxième (203) couches d'électrodes et la première couche de polymère isolant (201),
• un enroulement de l'empilement multicouche (20) au moins en partie sur lui-même autour d'une direction longitudinale (A2) pour former l'assemblage (2).

2. Procédé selon la revendication précédente, comprenant en outre :
• une fourniture d'une portion (10) de câble (1) haute tension comprenant une âme (11) s'étendant selon une direction d'extension principale (A1) du câble (1) et entourée autour de ladite direction par un matériau (13) à base du polymère électriquement isolant,
• une formation d'un film (200) à base du polymère électriquement isolant, par détourage de la portion (10) de câble haute tension (1) autour de la direction d'extension principale (A1) du câble (1), au moins une portion (200a) du film (200) étant utilisée lors de la formation de l'empilement multicouche (20).

3. Procédé selon l'une quelconque des revendications précédentes, comprenant, avant la formation du film (200), un vieillissement du câble haute tension (1) comprenant une exposition de la portion (10) de câble (1) à un courant électrique, et/ou dans lequel la portion (10) de câble (1) est issue d'un câble haute tension (1) auparavant utilisé.

4. Procédé selon l'une quelconque des revendications précédentes, dans lequel l'enroulement de l'empilement multicouche (20) est effectué sous une atmosphère de taux d'humidité contrôlé et/ou de taux d'oxygène contrôlé.

5. Procédé selon l'une quelconque des revendications précédentes, comprenant en outre, avant la formation de l'empilement multicouche (20), une sélection de la portion (200a) du film (200) pour former l'empilement multicouche (20), selon une position correspondante du matériau à base de polymère isolant électriquement dans le câble haute tension (1).

6. Procédé selon l'une quelconque des revendications précédentes, comprenant, avant la formation du film (200) :
• un dressage d'un pourtour latéral (100) de la portion (10) de câble (1), et/ou
• un dressage d'au moins une extrémité (10a, 10b) de la portion (10) de câble (1).

7. Assemblage (2) pour l'étude du vieillissement d'un câble haute tension (1), **caractérisé en ce que** l'assemblage (2) comprend un empilement multicouche (20) au moins en partie enroulé sur lui-même autour d'une direction longitudinale (A2), l'empilement multicouche (20) comprenant :
∘ une première (202) et une deuxième (203) couches, dites d'électrodes, à base d'un matériau électriquement conducteur,
∘ une première couche à base d'un polymère électriquement isolant du câble de haute tension dont le vieillissement est à étudier, dite première couche de polymère isolant (201), et disposée entre les première (202) et deuxième (203) électrodes, et
∘ une couche séparatrice (204) configurée pour isoler électriquement les première (202) et deuxième (203) couches d'électrodes entre elles, dans l'empilement multicouche (20) enroulé.

8. Assemblage (2) selon la revendication précédente, dans lequel au moins une parmi les première (202) et deuxième (203) couches d'électrodes dépasse au moins en partie de la première couche de polymère isolant (201) et de la couche séparatrice (204) selon la direction longitudinale (A2),
de préférence les première (202) et deuxième (203) couches d'électrodes sont disposées de façon décalée de la première couche de polymère isolant (201) et de la couche séparatrice (204) selon la direction longitudinale (A2), de sorte que :
• la première couche d'électrode (202) dépasse de la première couche de polymère isolant (201) et de la couche séparatrice (204) d'un premier côté (20a) de l'empilement multicouche (20) par rapport à la direction longitudinale (A2), sans dépasser sur un deuxième côté (20b) de l'empilement multicouche (20) opposé au premier côté (20a),
• la deuxième couche d'électrode (203) dépasse de la première couche de polymère isolant (201) et de la couche séparatrice (204) du deuxième côté (20b) de l'empilement multicouche (20), sans dépasser sur le premier côté (20a).

9. Assemblage (2) selon l'une quelconque des deux revendications précédentes, dans lequel la première couche de polymère isolant (201) présente une épaisseur comprise entre 50 µm et 200 µm.

10. Assemblage (2) selon l'une quelconque des trois revendications précédentes, dans lequel la couche séparatrice (204) est une deuxième couche à base du polymère électriquement isolant de câble de haute tension, dite deuxième couche de polymère isolant (204a), ou la couche séparatrice (204b) est une couche à base de polyimide.

11. Cellule (3) pour l'étude du vieillissement d'un câble haute tension (1), comprenant :
• l'assemblage (2) selon l'une quelconque des revendications 7 à 10, et
• une capsule (30) configurée pour alimenter électriquement l'assemblage (2), la capsule (30) comprenant :
∘ un corps (300), un premier bouchon (301) et un deuxième bouchon (302), définissant un volume intérieur clos (303), la capsule (30) étant configurée pour recevoir l'assemblage (2) dans le volume intérieur clos (303),
∘ deux électrodes (304, 305) chacune configurée pour raccorder une couche d'électrode (202, 203) distincte de l'assemblage (2),
de préférence le corps (300) et les premier (301) et deuxième (302) bouchons sont configurés pour définir le volume intérieur clos (303) de façon étanche.

12. Cellule (3) selon la revendication précédente, dans laquelle, dans l'assemblage (2), au moins une parmi les première (202) et deuxième (203) couches d'électrodes dépasse au moins en partie de la première couche de polymère isolant (201) et de la couche séparatrice (204) selon la direction longitudinale (A2), de façon à être en contact électrique avec l'électrode correspondante (304, 305) de la capsule (30), disposée en regard de ladite couche d'électrode (202, 203).

13. Cellule (3) selon l'une quelconque des deux revendications précédentes, dans laquelle chaque bouchon (301, 302) est électriquement conducteur et est relié électriquement avec une électrode (304, 305) de la capsule (30), et dans laquelle le corps (300) de la capsule (30) est configuré pour isoler électriquement les premier (301) et deuxième (302) bouchons entre eux,
et de préférence le corps (300) de la capsule (30) comprend :
• un premier manchon (300a) électriquement isolant entourant latéralement l'assemblage (2),
• un deuxième manchon (300b) métallique entourant latéralement le premier manchon (300a), le deuxième manchon étant en contact électrique avec le deuxième bouchon (302), et
• une collerette (306) électriquement isolante séparant le premier bouchon (301) du deuxième manchon (300b).

14. Système (4) comprenant plusieurs cellules (3) selon les trois revendications précédentes et un boitier (40) configuré pour recevoir et alimenter électriquement les cellules (3),
de préférence le système comprend un nombre de cellules (3) supérieur ou égale à 50, de préférence supérieur ou égale à 100,
et de préférence le boitier (40) comprend :
• un premier couvercle (401) comprenant plusieurs connecteurs électriques (401a), les connecteurs électriques (401a) étant configurés pour chacun connecter électriquement au moins une cellule (3), séparément de l'au moins une cellule (3) connectée par les autres connecteurs électriques (401a), et
• un deuxième couvercle (402) configuré pour connecter électriquement ensemble les connecteurs électriques (401a) du premier couvercle (401) à une source d'alimentation électrique (5) externe.

15. Procédé d'étude du vieillissement d'un câble haute tension (1) comprenant :
• une exposition d'au moins un assemblage (2) selon l'une quelconque des revendications 7 à 10, à un courant électrique,
au moins une mesure d'une propriété électrique, et par exemple de la résistance interne, d'au moins un assemblage (2) de façon à obtenir une donnée représentative du vieillissement d'un câble haute tension (1),
et de préférence le courant électrique présente une tension comprise entre 700 V et 17 000 V.

## Patentansprüche

1. Fertigungsverfahren einer Anordnung (2) zur Untersuchung der Alterung eines Hochspannungskabels (1), wobei das Verfahren Folgendes umfasst:
• Bilden einer mehrschichtigen Stapelung (20), die das mindestens teilweise Überlagern umfasst von:
o einer ersten Schicht, als Elektrodenschicht (202) bezeichnet, auf Basis eines elektrisch leitfähigen Materials,
o mindestens einer Schicht auf Basis eines elektrisch isolierenden Polymers, als erste Polymerisolierschicht (201) bezeichnet,
∘ einer zweiten Schicht, als Elektrodenschicht (203) bezeichnet, auf Basis eines elektrisch leitfähigen Materials derart, dass die erste Polymerisolierschicht (201) zwischen der ersten (202) und der zweiten (203) Elektrodenschicht angeordnet ist, und
o einer Trennschicht (204), die mindestens zum Teil mit der von der ersten (202) und der zweiten (203) Elektrodenschicht und der ersten Polymerisolierschicht (201) gebildeten Einheit überlagert ist,
• Aufrollen der mehrschichtigen Stapelung (20) mindestens zum Teil um sich selbst um eine Längsrichtung (A2), um die Anordnung (2) zu bilden.

2. Verfahren nach dem vorstehenden Anspruch, das außerdem Folgendes umfasst:
• Bereitstellen eines Abschnitts (10) eines Hochspannungskabels (1), das eine Seele (11) umfasst, die sich entlang einer Haupterstreckungsrichtung (A1) des Kabels (1) erstreckt und um die Richtung von einem Material (13) auf Basis von elektrisch isolierendem Polymer umgeben ist,
• Bilden eines Films (200) auf Basis des elektrisch isolierenden Polymers durch Ausschneiden des Abschnitts (10) des Hochspannungskabel (1) um die Haupterstreckungsrichtung (A1) des Kabels (1), wobei mindestens ein Abschnitt (200a) des Films (200) beim Bilden der mehrschichtigen Stapelung (20) verwendet wird.

3. Verfahren nach einem der vorstehenden Ansprüche, das vor dem Bilden des Films (200) ein Altern des Hochspannungskabels (1) umfasst, das eine Exposition des Abschnitts (10) des Kabels (1) gegenüber einem elektrischen Strom umfasst, und/oder wobei der Abschnitt (10) des Kabels (1) aus einem zuvor verwendeten Hochspannungskabel (1) stammt.

4. Verfahren nach einem der vorstehenden Ansprüche, wobei das Aufrollen der mehrschichtigen Stapelung (20) unter einer Atmosphäre unter kontrolliertem Luftfeuchtigkeitsgehalt und/oder kontrolliertem Sauerstoffgehalt erfolgt.

5. Verfahren nach einem der vorstehenden Ansprüche, das außerdem vor dem Bilden der mehrschichtigen Stapelung (20) ein Auswählen des Abschnitts (200a) des Films (200) zum Bilden der mehrschichtigen Stapelung (20) gemäß einer entsprechenden Position des Materials auf Basis von elektrisch isolierendem Polymer in dem Hochspannungskabel (1) umfasst.

6. Verfahren nach einem der vorstehenden Ansprüche, das vor dem Bilden des Films (200) Folgendes umfasst:
• Richten eines seitlichen Umfangs (100) des Abschnitts (10) des Kabels (1) und/oder
• Richten mindestens eines Endes (10a, 10b) des Abschnitts (10) des Kabels (1).

7. Anordnung (2) zur Untersuchung der Alterung eines Hochspannungskabels (1), **dadurch gekennzeichnet, dass** die Anordnung (2) eine mehrschichtige Stapelung (20) umfasst, die mindestens zum Teil auf sich selbst um eine Längsrichtung (A2) aufgerollt ist, wobei die mehrschichtige Stapelung (20) Folgendes umfasst:
o eine erste (202) und eine zweite (203) Schicht, als Elektroden bezeichnet, auf Basis eines elektrisch leitfähigen Materials,
o eine erste Schicht auf Basis eines elektrisch isolierenden Polymers des Hochspannungskabels, dessen Alterung untersucht werden soll, als erste Polymerisolierschicht (201) bezeichnet, und die zwischen der ersten (202) und der zweiten (203) Elektrode angeordnet ist, und
o eine Trennschicht (204), die dazu konfiguriert ist, die erste (202) und zweite (203) Elektrodenschicht voneinander in der aufgerollten mehrschichtigen Stapelung (20) zu isolieren.

8. Anordnung (2) nach dem vorstehenden Anspruch, wobei mindestens eine der ersten (202) und der zweiten (203) Elektrodenschicht mindestens zum Teil aus der ersten Polymerisolierschicht (201) und der Trennschicht (204) entlang der Längsrichtung (A2) vorragt,
die erste (202) und die zweite (203) Elektrodenschicht bevorzugt von der ersten Polymerisolierschicht (201) und der Trennschicht (204) entlang der Längsrichtung (A2) derart versetzt angeordnet sind, dass:
• die erste Elektrodenschicht (202) aus der ersten Polymerisolierschicht (201) und der Trennschicht (204) auf einer ersten Seite (20a) der mehrschichtigen Stapelung (20) in Bezug auf die Längsrichtung (A2) vorragt, ohne auf einer zweiten Seite (20b) der mehrschichtigen Stapelung (20), die der ersten Seite (20a) entgegengesetzt ist, vorzuragen,
• die zweite Elektrodenschicht (203) aus der ersten Polymerisolierschicht (201) und der Trennschicht (204) auf der zweiten Seite (20b) der mehrschichtigen Stapelung (20) vorragt, ohne auf der ersten Seite (20a) vorzuragen.

9. Anordnung (2) nach einem der zwei vorstehenden Ansprüche, wobei die erste Polymerisolierschicht (201) eine Dicke zwischen 50 µm und 200 µm aufweist.

10. Anordnung (2) nach einem der drei vorstehenden Ansprüche, wobei die Trennschicht (204) eine zweite Schicht auf Basis von elektrisch isolierendem Polymer eines Hochspannungskabels ist, als zweite Polymerisolierschicht (204a) bezeichnet, ist, oder die Trennschicht (204b) eine Schicht auf Polyimidbasis ist.

11. Zelle (3) zur Untersuchung der Alterung eines Hochspannungskabels (1), die Folgendes umfasst:
• die Anordnung (2) nach einem der Ansprüche 7 bis 10, und
• eine Kapsel (30,) die dazu konfiguriert ist, die Anordnung (2) mit Strom zu versorgen, wobei die Kapsel (30) Folgendes umfasst:
o einen Körper (300), einen ersten Stopfen (301) und einen zweiten Stopfen (302), die einen geschlossenen Innenraum (303) bilden, wobei die Kapsel (30) dazu konfiguriert ist, die Anordnung (2) in dem geschlossenen Innenraum (303) aufzunehmen,
o zwei Elektroden (304, 305), die jeweils dazu konfiguriert sind, eine Elektrodenschicht (202, 203), die von der Anordnung (2) getrennt ist, anzuschließen,
wobei bevorzugt der Körper (300) und der erste (301) und der zweite (302) Stopfen dazu konfiguriert sind, den geschlossenen Innenraum (303) auf dichte Art zu definieren.

12. Zelle (3) nach dem vorstehenden Anspruch, wobei in der Anordnung (2) mindestens eine der ersten (202) und der zweiten (203) Elektrodenschicht mindestens zum Teil aus der ersten Polymerisolierschicht (201) und der Trennschicht (204) entlang der Längsrichtung (A2) derart vorragt, dass sie mit der entsprechenden Elektrode (304, 305) der Kapsel (30), die gegenüber der Elektrodenschicht (202, 203) angeordnet ist, in elektrischem Kontakt steht.

13. Zelle (3) nach einem der beiden vorstehenden Ansprüche, wobei jeder Stopfen (301, 302) elektrisch leitfähig ist und elektrisch mit einer Elektrode (304, 305) der Kapsel (30) verbunden ist, und wobei der Körper (300) der Kapsel (30) dazu konfiguriert ist, den ersten (301) und den zweiten (302) Stopfen voneinander elektrisch zu isolieren,
und wobei der Körper (300) der Kapsel (30) bevorzugt Folgendes umfasst:
• eine erste elektrisch isolierende Hülse (300a), die die Anordnung (2) seitlich umgibt,
• eine zweite metallische Hülse (300b), die die erste Hülse (300a) seitlich umgibt, wobei die zweite Hülse mit dem zweiten Stopfen (302) elektrisch in Kontakt steht, und
• einen elektrisch isolierenden Bund (306), der den ersten Stopfen (301) von der zweiten Hülse (300b) trennt.

14. System (4), das mehrere Zellen (3) nach den drei vorstehenden Ansprüchen und ein Gehäuse (40) umfasst, das dazu konfiguriert ist, die Zellen (3) aufzunehmen und mit Strom zu versorgen,
wobei das System bevorzugt eine Anzahl von Zellen (3) größer oder gleich 50, bevorzugt größer oder gleich 100 umfasst,
und wobei das Gehäuse (40) bevorzugt Folgendes umfasst:
• einen ersten Deckel (401), der mehrere elektrische Steckverbinder (401a) umfasst, wobei die elektrischen Steckverbinder (401a) jeweils dazu konfiguriert sind, mindestens eine Zelle (3) elektrisch getrennt von der mindestens einen Zelle (3), die durch die anderen elektrischen Steckverbinder (401a) verbunden ist, zu verbinden, und
• einen zweiten Deckel (402), der dazu konfiguriert ist, elektrisch die elektrischen Steckverbinder (401a) des ersten Deckels (401) mit einer externen Stromquelle (5) gemeinsam zu verbinden.

15. Verfahren zur Untersuchung der Alterung eines Hochspannungskabels (1), das Folgendes umfasst:
• Exponieren mindestens einer Anordnung (2) nach einem der Ansprüche 7 bis 10 mit einem elektrischen Strom,
mindestens Messen einer elektrischen Eigenschaft und beispielsweise des Innenwiderstands mindestens einer Anordnung (2) derart, dass ein Wert gewonnen wird, der für die Alterung eines Hochspannungskabels (1) repräsentativ ist,
und wobei der elektrische Strom bevorzugt eine Spannung zwischen 700 V und 17.000 V aufweist.

## Claims

1. Method for manufacturing an assembly (2) for studying ageing of a high-voltage cable (1), the method comprising:
• a formation of a multilayer stack (20) comprising the at least partial superimposition:
∘ of a first so-called electrode layer (202), based on an electrically conductive material,
∘ of at least one layer based on an electrically insulating polymer, called first insulating polymer layer (201),
∘ of a second so-called electrode layer (203), based on an electrically conductive material, such that the first insulating polymer layer (201) is disposed between the first (202) and second (203) electrode layers, and
∘ of a separating layer (204) at least partially superimposed with the assembly formed by the first (202) and second (203) electrode layers and the first insulating polymer layer (201),
• a winding of the multilayer stack (20) at least partially on itself around a longitudinal direction (A2) to form the assembly (2).

2. Method according to the preceding claim, further comprising:
• a provision of a high-voltage cable (1) portion (10) comprising a core (11) extending along a main extension direction (A1) of the cable (1) and surrounded around said direction by a material (13) based on the electrically insulating polymer,
• a formation of a film (200) based on the electrically insulating polymer, by trimming of the high-voltage cable (1) portion (10) around the main extension direction (A1) of the cable (1), at least one portion (200a) of the film (200) being used during the formation of the multilayer stack (20).

3. Method according to any one of the preceding claims, comprising, before the formation of the film (200), an ageing of the high-voltage cable (1) comprising an exposure of the cable (1) portion (10) to an electric current, and/or wherein the cable (1) portion (10) comes from a high-voltage cable (1) used beforehand.

4. Method according to any one of the preceding claims, wherein the winding of the multilayer stack (20) is done under a controlled humidity rate and/or controlled oxygen rate atmosphere.

5. Method according to any one of the preceding claims, further comprising, before the formation of the multilayer stack (20), a selection of the portion (200a) of the film (200) to form the multilayer stack (20), according to a corresponding position of the electrically insulating polymer-based material in the high-voltage cable (1).

6. Method according to any one of the preceding claims, comprising, before the formation of the film (200):
• a straightening of a side perimeter (100) of the cable (1) portion (10), and/or
• a straightening of at least one end (10a, 10b) of the cable (1) portion (10).

7. Assembly (2) for studying ageing of a high-voltage cable (1), **characterised in that** the assembly (2) comprises a multilayer stack (20) at least partially wound on itself around a longitudinal direction (A2), the multilayer stack (20) comprising:
o a first (202) and a second (203) so-called electrode layer, based on an electrically conductive material,
o a first layer based on an electrically insulating polymer of the high-voltage cable, the ageing of which is to be studied, called first insulating polymer layer (201), and disposed between the first (202) and second (203) electrodes, and
o a separating layer (204), configured to electrically insulate the first (202) and second (203) electrode layers from one another, in the wound multilayer stack (20).

8. Assembly (2) according to the preceding claim, wherein at least one from among the first (202) and second (203) electrode layers at least partially exceeds the first insulating polymer layer (201) and the separating layer (204) along the longitudinal direction (A2),
preferably the first (202) and second (203) electrode layers are disposed offset from the first insulating polymer layer (201) and the separating layer (204) along the longitudinal direction (A2), such that:
• the first electrode layer (202) exceeds the first insulating polymer layer (201) and the separating layer (204) of a first side (20a) of the multilayer stack (20) with respect to the longitudinal direction (A2), without exceeding over a second side (20b) of the multilayer stack (20) opposite the first side (20a),
• the second electrode layer (203) exceeds the first insulating polymer layer (201) and the separating layer (204) of the second side (20b) of the multilayer stack (20), without exceeding over the first side (20a).

9. Assembly (2) according to any one of the two preceding claims, wherein the first insulating polymer layer (201) has a thickness of between 50µm and 200µm.

10. Assembly (2) according to any one of the three preceding claims, wherein the separating layer (204) is a second layer based on the high-voltage cable electrically insulating polymer, called second insulating polymer layer (204a), or the separating layer (204b) is a polyimide-based layer.

11. Cell (3) for studying ageing of a high-voltage cable (1), comprising:
• the assembly (2) according to any one of claims 7 to 10, and
• a capsule (30) configured to electrically power the assembly (2), the capsule (30) comprising:
o a body (300), a first stopper (301) and a second stopper (302), defining a closed inner volume (303), the capsule (30) being configured to receive the assembly (2) in the closed inner volume (303),
o two electrodes (304, 305), each configured to connect a distinct electrode layer (202, 203) of the assembly (2),
preferably the body (300) and the first (301) and second (302) stoppers are configured to sealingly define the closed inner volume (303).

12. Cell (3) according to the preceding claim, wherein, in the assembly (2), at least one from among the first (202) and second (203) electrode layers at least partially exceeds the first insulating polymer layer (201) and the separating layer (204) along the longitudinal direction (A2), so as to be in electric contact with the corresponding electrode (304, 305) of the capsule (30), disposed facing said electrode layer (202, 203).

13. Cell (3) according to any one of the two preceding claims, wherein each stopper (301, 302) is electrically conductive and is electrically connected with an electrode (304, 305) of the capsule (30), and wherein the body (300) of the capsule (30) is configured to electrically insulate the first (301) and second (302) stoppers from one another,
and preferably, the body (300) of the capsule (30) comprises:
• a first electrically insulating sleeve (300a) laterally surrounding the assembly (2),
• a second metal sleeve (300b) laterally surrounding the first sleeve (300a), the second sleeve being in electric contact with the second stopper (302), and
• an electrically insulating collar (306) separating the first stopper (301) from the second sleeve (300b).

14. System (4) comprising several cells (3) according to the three preceding claims and a casing (40) configured to receive and electrically power the cells (3), preferably, the system comprises a number of cells (3) greater than or equal to 50, preferably greater than or equal to 100,
and preferably the casing (40) comprises:
• a first cover (401) comprising several electric connectors (401a), the electric connectors (401a) being configured to each electrically connect at least one cell (3), separately from the at least one cell (3) connected by the other electric connectors (401a), and
• a second cover (402) configured to electrically connect together the electric connectors (401a) of the first cover (401) to an external electric power supply source (5).

15. Method for studying ageing of a high-voltage cable (1) comprising:
• an exposure of at least one assembly (2) according to any one of the preceding claims 7 to 10, to an electric current,
• at least one measuring of an electric property, and for example of the internal resistance, of at least one assembly (2), so as to obtain a representative piece of data of ageing of a high-voltage cable (1),
and preferably, the electric current has a voltage of between 700V and 17,000V.
